# EUROPEAN PATENT APPLICATION

(11) **EP 1 469 450 A1**
(43) Date of publication of application: **20.10.2004**
(21) Application number: 03447094.8
(22) Date of filing: 18.04.2003
(51) Int. Cl.: G09G 3/32

(54) **Organic light-emitting diode display assembly for use in a large-screen display**

(71) Applicant: BARCO N.V., 8500 Kortrijk (BE)
(72) Inventor: Van Hille, Herbert, Cambridge, MA 02138-5321 (US); Willem, Patrick, 8400 Oostende (BE); Thielemans, Robbie, 9810 Nazareth (BE); Chorng-Shyr, Jou, Yangmei Cheng, Taoyuan Hsien Taiwan (TW); Tung-Yang, Tang, Hsinchu, Taiwan 300 (TW)
(74) Representative: Donné, Eddy

(57) **Abstract**

Organic light-emitting diode display assembly for use in a large-screen display application, including a display device (112) comprising a plurality of organic light-emitting diodes (OLEDs) (310-312-314) having an anode and a cathode, said display assembly (100) further also including electrode lines formed by anode lines (1-2-3) and cathode lines (4 to 6, 7 to 12), and at least one drive device (118) comprising respective current sources (318), characterized in that the organic light-emitting diodes (OLEDs) (310-312-314) are arranged in a common anode configuration, said drive device (118) being configured as a common anode drive device (118).

## Description

### FIELD OF THE INVENTION

The present invention relates to an organic light-emitting diode display assembly for use in a large-screen display application, as well as to a large-screen display using such assemblies.

### BACKGROUND OF THE INVENTION

It is known that for displays use can be made of organic light-emitting diodes, abbreviated OLEDs.

OLED technology incorporates organic luminescent materials that, when sandwiched between electrodes and subjected to a DC electric current, produce intense light of a variety of colors. These OLED structures can be combined into the picture elements or pixels that comprise a display. OLEDs are also useful in a variety of applications as discrete light-emitting devices or as the active element of light-emitting arrays or displays, such as flat-panel displays in watches, telephones, laptop computers, pagers, cellular phones, calculators and the like. To date, the use of light-emitting arrays or displays comprising OLED technology has been largely limited to small-screen applications such as those mentioned above.

Demands for large-screen display applications possessing higher quality and higher resolution has led the industry to turn to alternative display technologies that replace older LED and liquid crystal displays (LCDs). For example, LCDs fail to provide the bright, high light output, larger viewing angles, and speed requirements that the large-screen display market demands while LEDs fail to meet the high resolution requirements at affordable cost. By contrast, OLED technology promises bright, vivid colors in high resolution and at wider viewing angles. However, the use of OLED technology in large-screen display applications, such as outdoor or indoor stadium displays, large marketing advertisement displays, and mass-public informational displays is still in the development stage.

Several technical challenges exist relating to the use of OLED technology in a large-screen application. One such challenge is that OLED displays are expected to offer a wide dynamic range of colors, contrast and light intensity depending on various external environmental factors including ambient light, humidity and temperature. Outdoor displays for example are at the same time required to produce more white color contrast during the day and display a large number of grey scales at night. Additionally, light output must be greater in bright sunlight and lower during darker, inclement weather conditions. The intensity of the light emission produced by an OLED device is directly proportional to the amount of current driving the device. Therefore, the more light output needed, the more current is fed to the pixel. Accordingly, less light emission is achieved by limiting the current to the OLED device.

A pixel, by definition, is a single point or unit of programmable color in a graphic image. However, a pixel may include an arrangement of sub-pixels, for example, red, green and blue sub-pixels.

Conventional OLED displays are arranged according to a common cathode configuration, and are consequently driven by means of a common cathode drive circuit. In such common cathode drive circuit, a current source is arranged between each individual anode and a positive power supply, while the cathodes are electrically connected in common to ground. Consequently, the current and voltage are not independent of one another, and small voltage variations result in fairly large current variations, having the further consequence of light output variations. Furthermore, in the common cathode configuration, the constant current source is referenced to the positive power supply, so again any small voltage variation results in a current variation. For these reasons, the common cathode configuration makes precise control of light emission, which is dependent upon precise current control, more difficult.

Another consideration in a large-screen display application using OLED technology is the physical size of the pixel. A larger emission area is more visible and lends itself to achieving the required wide dynamic range of colors, contrast and light intensity. Consequently, an OLED device structure having a larger area than OLED structures of conventional small-screen displays is desirable. In a small-screen application, the pixel pitch is typically 0,3 mm or less and the pixel area is, for example, only 0,1 mm². By contrast, in a large-screen application, the pixel pitch may be 1.0 mm or greater, thereby allowing the pixel area to be as large as 0.3 to 50 mm² (pitch varies up to 10 mm with fill factors of 50%). However, a consequence of the larger device area is the relatively high inherent capacitance of the larger OLED device as compared with small OLED structures. Due to this high inherent capacitance, in operation, an additional amount of charge time is required to reach the OLED device threshold voltage. This charge time limits the on/off rate of the device and thus adversely affects the overall display brightness and performance. Furthermore, besides the OLED structures themselves, other sources of capacitance must be considered when designing OLED drive circuits, such as the additional line resistance and capacitance of wiring within the physical packaging.

A further consideration in a large-screen display application using OLED technology is the large screen assembly itself. A well-known tiling technique may be used to achieve the large two-dimensional screen area. More specifically, a matrix of smaller OLED display devices are arranged in rows and columns into what appears to the viewer as a seamless large display. As a result, a further technical challenge is to develop packaging techniques for OLED display assemblies that, when assembled, achieve this seamless large-screen display.

An example of an OLED display assembly is found in U.S. patent application No. 2002/0084536, entitled, "Interconnected circuit board assembly and method of manufacture thereof." This patent application describes an electrical assembly that is formed from two interconnected circuit boards. Conductive spacers and a conductive material are placed between complementary bond pads on the circuit boards. The conductive spacers are formed from a material that maintains its mechanical integrity during the process of attaching the circuit boards. The conductive material is a solder or conductive adhesive used to mechanically attacn the circuit boards. In addition, an insulating material is inserted into an interface region between the circuit boards. The insulating material provides additional mechanical connection between the circuit boards. In one embodiment, one circuit board includes a glass panel that holds an array of OLEDs, and the other circuit board is a ceramic circuit board. Together, the interconnected circuit board assembly forms a portion of a flat panel display. However, the circuit board assembly of this known patent application is not suitable for use in a large-screen display application.

### SUMMARY OF THE INVENTION

It is therefore a first object of the invention to provide an organic light-emitting diode display assembly whicn is improved with respect to the conventional OLED displays which use the common cathode configuration.

To this end, the present invention provides an organic light-emitting diode display assembly for use in a large-screen display application, including a display device comprising a plurality of organic light-emitting diodes (OLEDs) having an anode and a cathode, said display assembly further also including electrode lines formed by anode lines and cathode lines, and at least one drive device comprising respective current sources, said display assembly being characterized in that the organic ligh-emitting diodes (OLEDs) are arranged in a common anode configuration, said drive device being configured as a common anode drive device.

Preferably, in this organic light-emitting diode display assembly, the current sources are referenced to ground, more particularly are arranged between each individual cathode of the respective OLED and ground.

Furthermore, the anodes of the respective OLEDs are electrically connected in common to a positive power supply.

As a result of using a common anode configuration, which is totally unusual for OLED displays, and contrary to the known common cathode configuration, the current and voltage are largely independent of one another, and small voltage variations do not result in current variations, thereby eliminating the further consequence of light output variations. As, furthermore, in the claimed common anode configuration, the constant current source preferably is referenced to ground, which does not vary, any current variations due to its reference are eliminated. For these reasons, the claimed common anode configuration lends itself to the precise control of light emission needed in a large-screen display application.

It is another object of the present invention to provide an OLED display assembly which is provided with an improved arrangement of electrical connections, resulting in that the display is further optimized for use in the afore-mentioned common anode configuration.

It is yet another object of this invention to provide an OLED display assembly and structure suitable to overcome the high parasitic series resistance of the material which is used for the electrode lines in the OLED display device. When using typical materials for this, such as thin film indium-thin oxide (ITO) for anodes in a common anode configuration, the parasitic series resistance may disturb the good functioning of the display.

It is yet another object of this invention to provide an OLED display assembly and structure suitable to overcome the high parasitic capacitance of the OLED device itself in a common anode configuration for a large-screen display application.

It is yet another object of this invention to provide an OLED display assembly and structure suitable for tiling such that a seamless large-screen display is achieved.

In order to realize one or more of the above additional objects, the organic light-emitting diode display assembly of the invention, preferably is further characterized in that at least a portion of said display device is back-coupled by means of respective electrical connections to at least one backing element via an interconnect system. Still more preferably, all electrical connections of the display device are back-coupled to at least one backing element.

By using an arrangement in which electrical connections of the display device are back-coupled to at least one backing element via an interconnect system, in other words by providing local interconnections from distinct locations at the back side of the display device towards corresponding, or substantially corresponding, locations at the backing element, new possibilities are created which are extremely advantageous in combination with a common anode configuration of OLEDs.

For example such arrangement allows that the interconnection region of the electrode lines to the electronics of a drive device, in other words to the display driver, can be moved away from the edges of a display array, thereby reducing the required minimum seams between tiles for a tiled display. More particularly, by the arrangement of the invention, the use of flexible connecting strips extending from the edge of a display tile can be excluded, and a seamless large screen-display can be realized. Hereby, with seamless is meant that the distance between two subsequent pixels belonging to a tile and an adjacent tile corresponds or substantially corresponds with the distance between two subsequent pixels within one tile.

Preferably, said backing element consists of a printed circuit board (PCB), extending along the back side of the display device. Still more preferably, at least part of the electronic components of the driver circuit used to drive the OLEDs of the respective tile are mounted on the side of the printed circuit board opposite to the side at which the interconnect system is provided. In this way, a very compact tile-shaped structure is obtained, which substantially consists of a display device which is backed by means of a printed circuit board comprising at least a number of components of the corresponding driver circuit.

According to a particular aspect of the present invention, the display device comprises a plurality of electrode lines, at least a number of this electrode lines comprising connections which are back-coupled to corresponding conductive lines on the backing element, so as to reduce the parasitic series resistance of the conductive material used for said electrode lines.

According to a further particular aspect, at least a number of the connections are back-coupled to corresponding conductive lines on the backing element, or, in other words, on the printed circuit board, so as to reduce the parasitic capacitance of the OLED display device itself.

Further particular features and advantages of the invention will become clear from the detailed description and the claims.

### BRIEF DESCRIPTION OF THE DRAWINGS

With the intention of better showing the characteristics of the invention, hereafter, as example without any limitative character, a preferred form of embodiment is described, with reference to the accompanying drawings, wherein:
Figure 1 shows a schematic representation of a display assembly in accordance with the invention, in top view;
Figure 2 shows a side view of the display assembly of figure 1, also in a schematic form;
Figure 3 shows a small segment of a pixel array within the display assembly of the invention;
Figure 4 shows a schematic diagram of an OLED drive circuit for use with the pixel array in accordance with the invention;
Figure 5 shows a top view of the physical layout of the OLED display device used in the display assembly of the invention;
Figure 6 shows a cross-sectional view of the OLED display device of the present invention taken along line VI-VI of figure 5;
Figure 7 shows a cross-sectional view of the OLED display device of the present invention taken along line VII-VII of figure 5;
Figure 8 shows a cross-sectional view of the OLED display device of the present invention taken along line VIII-VIII of figure 5;
Figure 9 shows a cross-sectional view of the OLED display device of the present invention taken along line IX-IX of figure 5;
Figure 10 shows a cross-sectional view of the OLED display assembly of the present invention taken along line X-X of figure 1.

### DETAILED DESCRIPTION OF PREFERRED EMBODIMENT

The present invention is an OLED display assembly or structure suitable for use in a large-screen display application. In other words a number of such display assemblies can be mounted in rows and columns in order to form a large-screen display. The OLED display assembly of the present invention includes a pixel array device hereafter called display device, arranged in a passive matrix common anode configuration, a printed circuit board (PCB) for mounting the drive circuitry devices, and a back-coupled interconnect system sandwiched therebetween that provides electrical connections to and from the pixel array device and the PCB. Furthermore, the OLED display assembly of the present invention includes multiple anode and cathode interconnections, thereby providing redundancy for reducing the parasitic resistance and capacitance of the lines.

OLED materials exist in different categories, for example, small-molecule OLED technology used by Eastman Kodak (Rochester, NY), polymer OLED technology developed and used by Cambridge Display Technology (Cambridge, UK), Dow Chemical (Midland, MI) and Covion Organic Semiconductors GmbH (Frankfurt, Germany), dendrimer OLED technology used by Cambridge Display Technology (Cambridge, UK), and phosphorescent OLED technology used by Universal Display Corporation (Ewing, NJ). The OLED display assemblies and structures for use in large-screen display applications as disclosed below are suitable for use with all of the above-mentioned OLED materials.

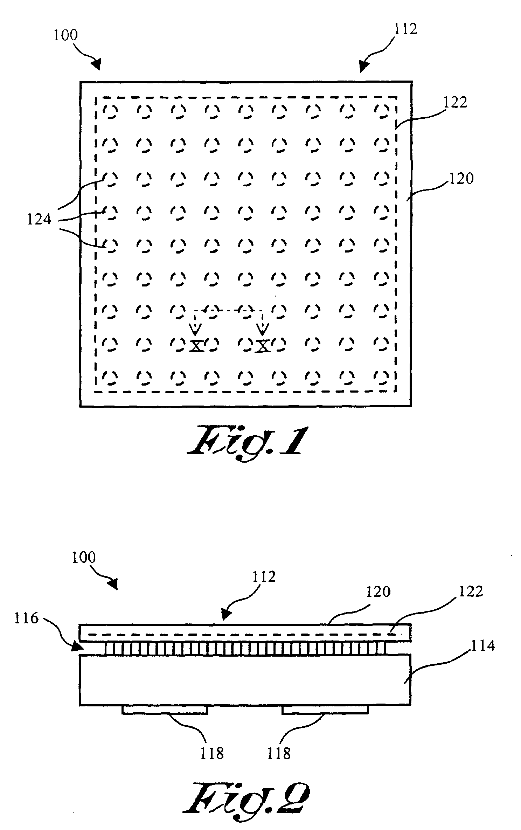

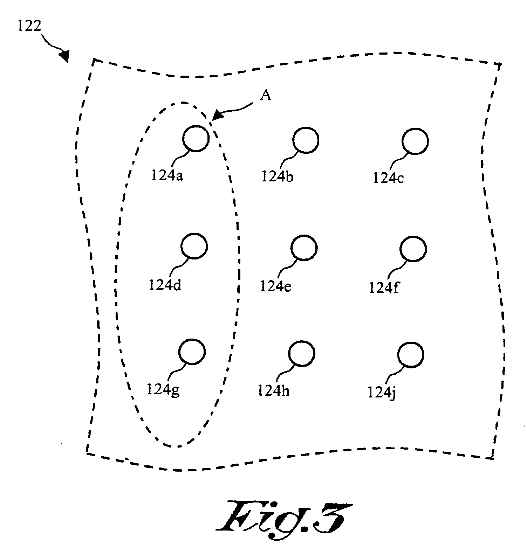

Figures 1 and 2 illustrate a top and side view, respectively, of an OLED display assembly 100 (not drawn to scale) in accordance with the invention. OLED display assembly 100 includes an OLED display device 112 that is back-coupled to a printed circuit board or PCB 114 via an interconnect system 116. Mounted on the side of PCB 114, opposite to interconnect system 116, is a plurality of drive/control devices 118.

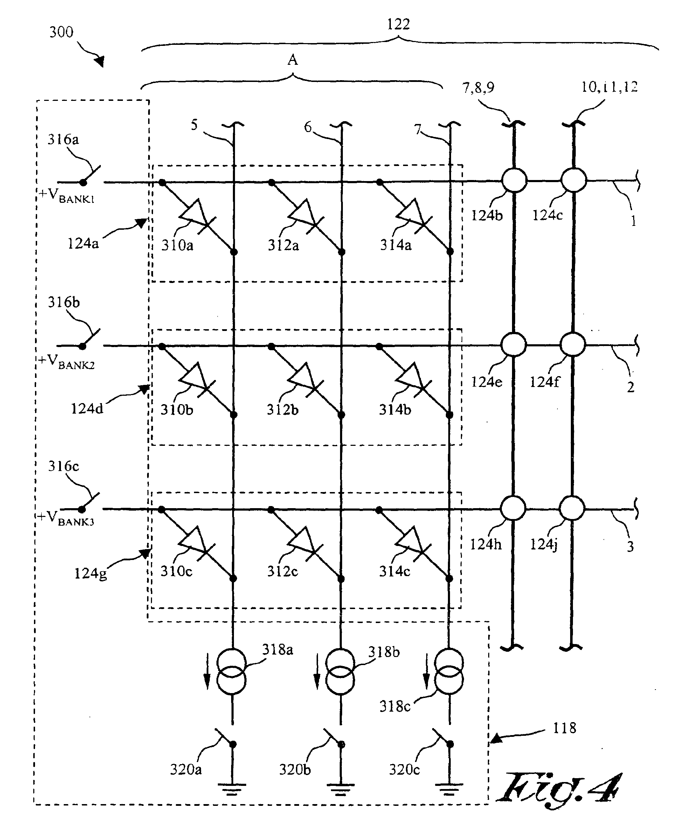

OLED display device 112 further includes a substrate 120 formed of a non-conductive, transparent material, such as glass. Deposited upon substrate 120 is a pixel array 122 formed of a plurality of pixels 124 arranged in a matrix. PCB 114 is a conventional PCB formed of a material such as ceramic or FR4, as is well known. PCB 114 includes wiring to facilitate electrical signal and power connections to and from OLED display device 112 and drive/control devices 118. A pattern of vias for electrically connecting to substrate 120 of OLED display device 112 emerges at the surface of OLED display device 112 facing PCB 114. Likewise, a pattern of vias for electrically connecting to the wiring of PCB 114 emerges at the surface of PCB 114 facing OLED display device 112. The via pattern of PCB 114 is a mirror image of the via pattern of OLED display device 112. OLED display device 112 and PCB 114 are physically aligned such that interconnect system 116, which is sandwiched therebetween, provides electrical connections between the vias of OLED display device 112 and the vias of PCB 114 that subsequently connect to drive/control devices 118. Those skilled in the art will appreciate that various standard signal and power connections existing upon PCB 114 are, for simplicity, not shown. Interconnect system 116 is any well-known back-coupling attachment technique that provides low capacitance, low resistance electrical paths, such as solderball attachment technology, elastomers or pogo-pins. Figures 3 through 10 provide greater detail of the circuit layout and structure of OLED display assembly 100.

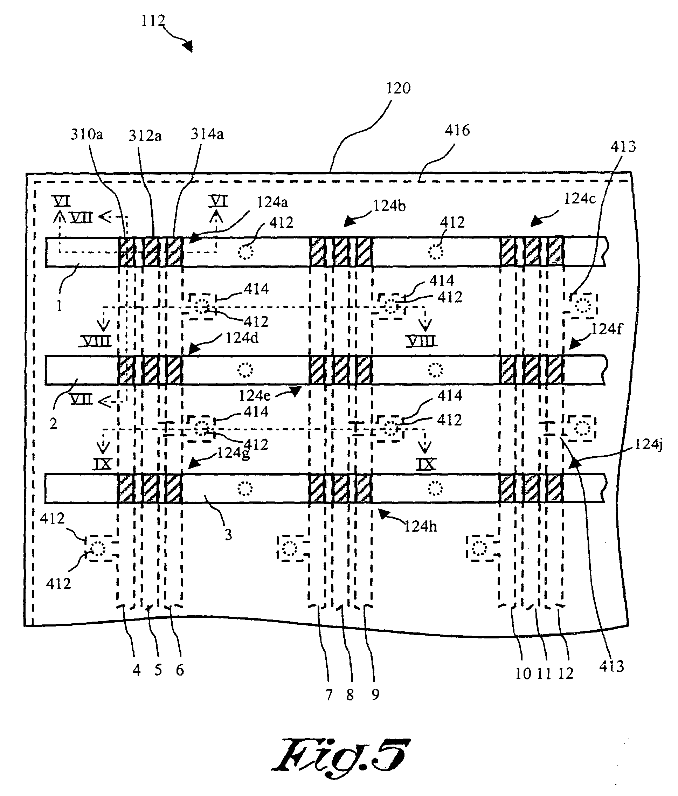

Figure 3 illustrates a small segment of pixel array 122 in accordance with the invention. More specifically, figure 3 illustrates, for example, a 3x3 matrix of pixels 124, i.e., a pixel 124a, a pixel 124b, a pixel 124c, a pixel 124d, a pixel 124e, a pixel 124f, a pixel 124g, a pixel 124h, and a pixel 124j arranged in rows and columns. Furthermore, pixel 124a, pixel 124d, and pixel 124g are included in a detail A that is further illustrated in figure 4.

Figure 4 illustrates a schematic diagram of an OLED drive circuit 300 in accordance with the invention for use with the segment of pixel array 122 as shown in figure 3. More specifically, detail A of figure 3 is expanded to show that pixel array 122 is formed of a plurality of red OLEDs (R-OLEDs) 310, green OLEDs (G-OLEDs) 312, and blue OLEDs (B-OLEDs) 314, which are sub-pixels for forming pixels 124. Each pixel 124 includes an R-OLED 310, a G-OLED 312, and a B-OLED 314. For example, pixel 124a includes an R-OLED 310a, a G-OLED 312a, and a B-OLED 314a; pixel 124d includes an R-OLED 310b, a G-OLED 312b, and a B-OLED 314b; and pixel 124g includes an R-OLED 310c, a G-OLED 312c, and a B-OLED 314c. Each OLED 310, 312, or 314 emits light when forward biased in conjunction with an adequate current supply, as is well known.

The OLED array of figure 4 shows that, in accordance with the present invention, a common anode configuration is applied. The anodes of R-OLED 310a, G-OLED 312a, and B-OLED 314a are electrically connected to an anode line 1, the anodes of R-OLED 310b, G-OLED 312b, and B-OLED 314b are electrically connected to an anode line 2, and the anodes of R-OLED 310c, G-OLED 312c, and B-OLED 314c are electrically connected to an anode line 3. Furthermore, the cathodes of R-OLEDs 310a, 310b, and 310c are electrically connected to a cathode line 4, the cathodes of G-OLEDs 312a, 312b, and 312c are electrically connected to a cathode line 5, and the cathodes of B-OLEDs 314a, 314b, and 314c are electrically connected to a cathode line 6.

A positive voltage (+V_{BANK}), typically ranging between 3 volts (i.e., threshold voltage 1,5V - 2V + voltage over current source, usually 0,7 V) and 15-20 volts, is electrically connected to each respective anode line via a plurality of switches 316. Switches 316 are conventional active switch devices, such as MOSFET switches or transistors having suitable voltage and current ratings. More specifically, a +V_{BANK1} is electrically connected to anode line 1 via a switch 316a, a +V_{BANK2} is electrically connected to anode line 2 via a switch 316b, and a +V_{BANK3} is electrically connected to anode line 3 via a switch 316c. A current source (I_{SOURCE}) 318 is electrically connected to each respective cathode line via a plurality of switches 320. More specifically, an I_{SOURCE} 318a drives cathode line 4. Connected in series between I_{SOURCE} 318a and ground is a switch 320a. An I_{SOURCE} 318b drives cathode line 5. Connected in series between I_{SOURCE} 318b and ground is a switch 320b. An I_{SOURCE} 318c drives cathode line 6. Connected in series between I_{SOURCE} 318c and ground is a switch 320c. I_{SOURCE}S 318 are conventional current sources capable of supplying a constant current typically in the range of 5 to 50 mA. Examples of constant current devices include a Toshiba TB62705 (8-bit constant current LED driver with shift register and latch functions) and a Silicon Touch ST2226A (PWM-controlled constant current driver for LED displays). Switches 320 are conventional active switch devices, such as MOSFET switches or transistors having suitable voltage and current ratings. +V_{BANK1}, +V_{BANK2}, and +V_{BANK3}, the plurality of switches 316, the plurality of I_{SOURCE}S 318, and the plurality of switches 320 are elements disposed within drive/control devices 118, and are thus located external to but electrically connected to OLED display device 112.

In operation, to activate (light up) any given R-OLED 310, G-OLED 312, or B-OLED 314, its associated anode line and cathode line are activated by simultaneously closing their associated switches 316 and 320. In a first example, to light up G-OLED 312a, +V_{BANK1} is applied to anode line 1 by closing switch 316a and, simultaneously, a constant current is supplied to cathode line 5 via I_{SOURCE} 318b by closing switch 320b. In this way, G-OLED 312a is forward biased and current flows through G-OLED 312a. Once the device threshold voltage of typically 0,7 volts is achieved at its cathode, G-OLED 312a emits light. G-OLED 312a remains lit up as long as switch 316a and switch 320b remain closed. To deactivate G-OLED 312a, switch 320b is opened. In a second example, to light up R-OLED 310c, +V_{BANK3} is applied to anode line 3 by closing switch 316c and, simultaneously, a constant current is supplied to cathode line 4 via I_{SOURCE} 318a by closing switch 320a. In this way, R-OLED 310c is forward biased and current flows through R-OLED 310c. Once the device threshold voltage of typically 0,7 volts is achieved at its cathode, R-OLED 310c emits light. R-OLED 310c remains lit up as long as switch 316c and switch 320a remain closed. To deactivate R-OLED 310c, switch 320a is opened. Along a given anode line, any one or more red, green, or blue OLEDs may be activated at any given time. By contrast, along a given cathode line, only one OLED may be activated at any given time.

Pixels 124b, 124c, 124e, 124f, 124h, and 124j, each containing an R-OLED 310, a G-OLED 312, and a B-OLED 314, are similarly arranged. More specifically, pixels 124b and 124c are arranged along anode line 1, pixels 124e and 124f are arranged along anode line 2, and pixels 124h and 124j are arranged along anode line 3. Furthermore, pixels 124b, 124e, and 124h are driven by cathode lines 7, 8, and 9, each having an associated I_{SOURCE} 318 (not shown); while pixels 124c, 124f, and 124j are driven by cathode lines 10, 11, and 12, each having an associated I_{SOURCE} 318 (not shown) .

The matrix of OLEDs within OLED drive circuit 300, as shown in figure 4, are in accordance with the invention arranged in a common anode configuration. In this way, the current and voltage are independent of one another, providing better control of the light emission.

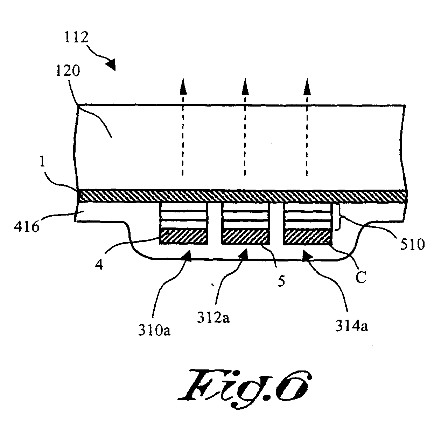

Figure 5 illustrates a top view (not to scale) of a portion of OLED display device 112 showing the physical layout of, for example, pixels 124a, 124b, 124c, 124d, 124e, 124f, 124g, 124h, and 124j arranged in rows and columns, as described with respect to figures 3 and 4.

Figure 5 shows anode lines 1, 2, and 3 arranged in parallel along substrate 120 and equally spaced apart. Each anode line is formed of a thin film layer of conductive transparent material, such as indium-tin oxide (ITO), that is deposited by, for example, a well-known thin film deposition process such as sputtering. Deposited upon the ITO, or any other suitable material, of each anode line are multiple pixels 124, each including an R-OLED 310, a G-OLED 312, and a B-OLED 314, as shown in figure 4. For example, R-OLED 310, G-OLED 312, and B-OLED 314 of pixels 124a, 124b, and 124c are deposited upon the ITO forming anode line 1; R-OLED 310, G-OLED 312, and B-OLED 314 of pixels 124d, 124e, and 124f are deposited upon the ITO forming anode line 2; and R-OLED 310, G-OLED 312, and B-OLED 314 of pixels 124g, 124h, and 124j are deposited upon the ITO forming anode line 3. Each R-OLED 310, G-OLED 312, and B-OLED 314 is formed by depositing a stack of a hole injecting layer (optional), a hole transport layer (optional), organic electroluminescent (EL) emission material and an electron transport layer (optional) upon its associated anode line by, for example, a well-known shadow mask process.

Figure 5 further shows cathode lines 4 through 12 arranged in parallel along substrate 120. Multiple sets of three cathode lines are equally spaced apart. Cathode lines 4 through 12 are oriented orthogonal to anode lines 1, 2, and 3. Each cathode line is formed of a thin film layer of conductive material, such as aluminum or magnesium silver, which is deposited by, for example, a well-known sputtering process. The cathode lines are deposited on the side of the EL material of R-OLEDs 310, G-OLEDs 312, and B-OLEDs 314 that is opposite the anode lines; thus, each R-OLED 310, G-OLED 312, and B-OLED 314 is formed via a stack of EL material arranged between an anode line and a cathode line. For example, cathode line 4 spans across anode lines 1, 2, and 3, thereby allowing R-OLED 310a of pixel 124a, R-OLED 310b of pixel 124d, and R-OLED 310c of pixel 124g to be formed. Cathode line 5 spans across anode lines 1, 2, and 3, thereby allowing G-OLED 312a of pixel 124a, G-OLED 312b of pixel 124d, and G-OLED 312c of pixel 124g to be formed. Cathode line 6 spans across anode lines 1, 2, and 3, thereby allowing B-OLED 314a of pixel 124a, B-OLED 314b of pixel 124d, and B-OLED 314c of pixel 124g to be formed. Pixels 124b, 124c, 124e, 124f, 124h, and 124j are formed in similar fashion. As a result, a first dimension of each R-OLED 310, G-OLED 312, and B-OLED 314 is equivalent to the width of its associated anode line, which for example is 0,55 to 7,07 mm. A second dimension of each R-OLED 310, G-OLED 312, and B-OLED 314 is equivalent to the width of its associated cathode line, which for example is 0,16 to 2,35 mm.

Lastly, electrical connections to and from OLED display device 112 are provided to each anode line and cathode line by way of a plurality of vias 412. Each via 412 is formed of a column of conductive material, such as copper or aluminum, as is well known or in simplest form provided as an opening leaving free access to the electrode beneath. In the latter case, the exposure to oxygen, water and other oxidants or pollutants should be limited in time to avoid the build up of a contact resistance which would impede electrical back-coupling. Vias 412 may be formed by dry etching and/or using selective masking steps. Each via 412 provides a vertical connection to the outer surface of OLED display device 112. Multiple vias 412 are distributed along each anode line and cathode line, thereby providing redundant connection points and thus reducing the capacitance and resistance associated with these electrical connections. A common anode configuration was up to now not used in conventional OLED displays amongst other because of the high parasitic series resistance due to the resistance of the ITO material used for the anode lines. However, this high parasitic resistance problem is overcome within OLED display device 112 using a high degree of redundant vias 412, which allows a back-coupling technique. The back-coupling technique in combination with redundant vias 412 provides the further advantage of reducing the parasitic capacitance of the OLED devices.

The anode lines are suitably wide to allow vias 412 to be located directly in line with each anode line and to contact their surfaces, as shown in figure 5. By contrast, the cathode lines may be chosen narrow, and consequently may be too narrow to allow vias 412 to be located directly in line. To solve this problem a wire trace 413 or the like to a pad 414 may be provided to facilitate each via 412 connecting to the cathode lines, as shown in figure 5.

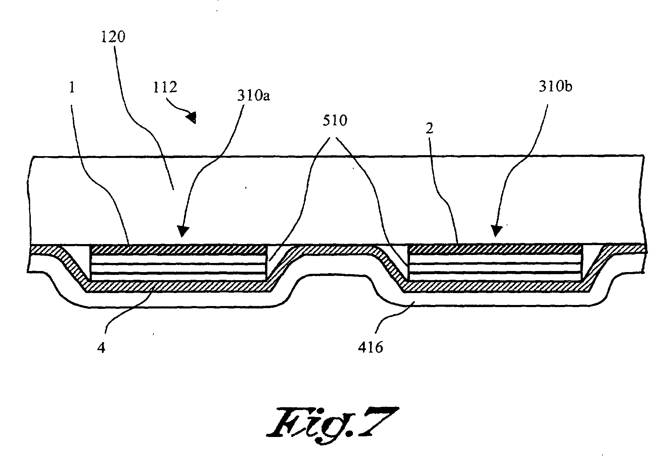

An encapsulation layer 416 (or passivation layer) on the non-emissive side of OLED display device 112 ensures that the OLED structures are not exposed to contaminants, such as moisture or particulates. Encapsulation layer 416 is formed of at least one layer of non-conductive barrier material, organic or inorganic or a combination, such as parylene or silicon nitride (Si₃N₄). Further details of the structure of OLED display device 112 are shown in figures 6 through 9.

Figure 6 illustrates a cross-sectional view (not to scale) of OLED display device 112 taken along line VI-VI of figure 5. This view illustrates how ITO is deposited upon one surface of substrate 120 to form anode line 1. Subsequently, three stacks of EL layers 510 are deposited upon the surface of anode line 1 opposite substrate 120. Upon a first stack of EL layers 510 is deposited cathode line 4, upon a second stack of EL layers 510 is deposited cathode line 5, and upon a third stack of EL layers 510 is deposited cathode line 6, thereby forming R-OLED 310a, G-OLED 312a, and B-OLED 314a of pixel 124a. Finally, encapsulation layer 416 is applied using thin-film deposition processes over the non-emissive side of OLED display device 112, thereby ensuring that the OLED structures are not exposed to contaminants, such as moisture or particulates. The thickness of substrate 120 is typically 0,1 to 1,1 mm. The thickness of cathode lines 4, 5, and 6 is typically 100 to 170 nm.

In operation, when an electrical potential is placed across EL layers 510 of R-OLED 310a, G-OLED 312a, or B-OLED 314a via the anode line 1 and cathode line 4, 5, or 6, respectively, light emission results.

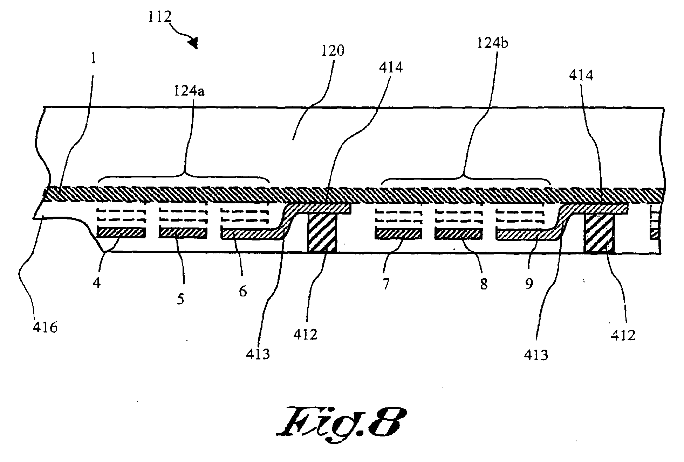

Figure 7 illustrates a cross-sectional view (not to scale) of OLED display device 112 taken along line VII-VII of figure 5. This view illustrates how ITO is deposited upon one surface of substrate 120 to form anode lines 1 and 2. Subsequently, stacks of EL layers 510 are deposited upon the surface of ANODE LINE 1 and upon the surface of ANODE LINE 2 opposite substrate 120. Spanning across both stacks of EL layers 510 is deposited a cathode line 4, thereby forming R-OLED 310a of pixel 124a and R-OLED 310b of pixel 124d. Finally, encapsulation layer 416 is applied over the non-emissive side of OLED display device 112, as already described with reference to figure 6.

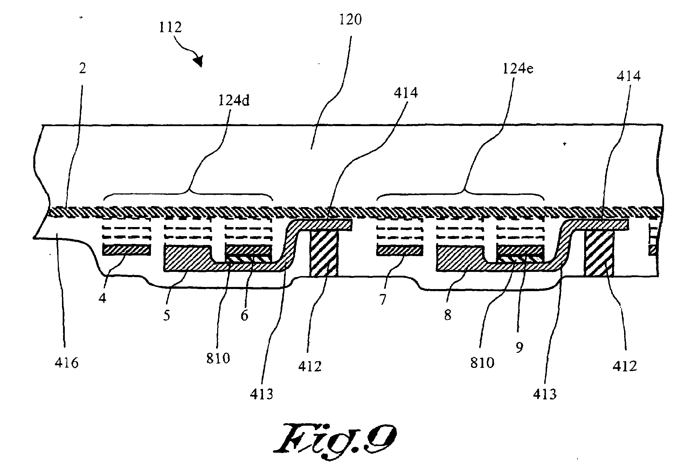

Figure 8 illustrates a cross-sectional view (not to scale) of OLED display device 112 taken along line VIII-VIII of figure 5. This view is intended to illustrate the inclusion of vias 412 within the structure of OLED display device 112. For example, figure 8 illustrates a first via 412 in contact with a first pad 414 that is electrically connected with a short wire trace 413 to cathode line 6 in an unobstructed fashion. Similarly, a second via 412 is in contact with a second pad 414 that is electrically connected with a short wire trace 413 to cathode line 9 in an unobstructed fashion. The outer ends of vias 412 are exposed through encapsulation layer 416, as shown in figure 8, such that external electrical and mechanical contact is possible.

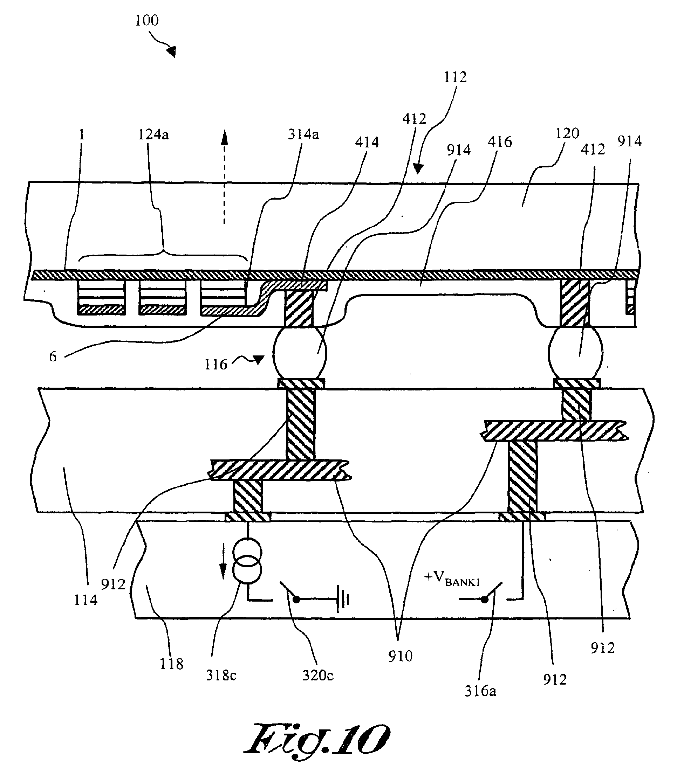

Figure 9 illustrates a cross-sectional view (not to scale) of OLED display device 112 taken along line IX-IX of figure 5. This view is also intended to illustrate the inclusion of vias 412 within the structure of OLED display device 112. For example, figure 9 illustrates a first via 412 in contact with a first pad 414 that is electrically connected with a short wire trace 413 to cathode line 5. Similarly, a second via 412 is in contact with a second pad 414 that is electrically connected with a short wire trace to cathode line 8. In the first case, cathode line 6 forms an obstruction in the wire trace path between cathode line 5 and the first pad 414. Consequently, a first insulation layer 810 formed of either an inorganic material, such as Si₃N₄, or an organic material, such as parylene or epoxies, is deposited atop cathode line 6 such that the wire trace from cathode line 5 may pass over cathode line 6 toward first pad 414 without forming an electrical short. Similarly, in the second case, cathode line 9 forms an obstruction in the wire trace path between cathode line 8 and second pad 414. Consequently, a second insulation layer 810 is deposited atop cathode line 9 such that the wire trace from cathode line 8 may pass over cathode line 9 toward the second pad 414 without forming an electrical short. Again, the outer ends of vias 412 are exposed through encapsulation layer 416, as shown in figure 9, such that external electrical and mechanical contact is possible.

Figure 10 illustrates a cross-sectional view (not to scale) of OLED display assembly 100 taken along line X-X of figure 1. This view is intended to illustrate the full structure of OLED display assembly 100, showing one complete electrical path using, as an example, B-OLED 314a of pixel 124a. Figure 10 shows a cross-section of OLED display device 112 as described in figures 5 through 9. A cross-sectional view of PCB 114 shows that PCB 114 includes a plurality of internal wires 910 that are electrically connected to a plurality of vias 912 for connection to external devices. Each via 912 is formed of a column of conductive material, such as magnesium silver or aluminum, as is well known. Each via 912 provides a vertical connection to the outer surface of PCB 114. Vias 912 that face OLED display device 112 align with the footprint of vias 412 of OLED display device 112, thereby allowing a plurality of solderballs 914 of interconnect system 116 to be arranged therebetween. Thus, an electrical path is formed between OLED display device 112 and PCB 114. Solderballs 914 are formed of for example a lead-tin compound as is well known. As an alternative to solderballs 914, the electrical connections between OLED display device 112 and PCB 114 are formed of other materials, such as anisotropic conductive adhesives (ACA) or z-axis materials, or silver filled epoxies. Furthermore, vias 912 that extend to the drive/control devices 118 side of PCB 114 align with the device footprint of drive/control devices 118, which are typically surface-mount devices, thereby allowing the I/O pins of drive/control devices 118 to be electrically bonded to pads connecting to vias 912. OLED display assembly 100 is formed by aligning interconnect system 116 between OLED display device 112 and PCB 114, and subsequently pressing the elements together and heating to allow solderballs 914 of interconnect system 116 to bond or, in the case of adhesives, to allow curing.

The use of other interconnect systems is not excluded.

Although not specifically shown in figure 10, anode lines are formed by internal wires 910 of PCB 114 that are physically arranged in parallel with the anode lines within OLED display device 112, thus greatly reducing or possibly eliminating completely the parasitic resistance of the ITO material of the anode lines within OLED display device 112. For any given anode line, the resulting ITO resistance is associated with only one half of the distance between two vias 412. The problem of sending high current through ITO conductors is thus solved.

In this example, switch 316a of drive/control devices 118 is electrically connected to ANODE LINE 1 of OLED display device 112 by vias 912 and wires 910 of PCB 114, a solderball 914, and a via 412 of OLED display device 112 that connects to anode line 1, upon which is deposited the EL layers of B-OLED 314a of pixel 124a. Furthermore, I_{SOURCE} 318c of drive/control devices 118 is electrically connected to cathode line 6 of OLED display device 112 by vias 912 and wires 910 of PCB 114, a solderball 914, and a via 412 of OLED display device 112 that connects to cathode line 6 of B-OLED 314a of pixel 124a. In this way, the physical and electrical paths of this drive circuit are illustrated. Furthermore, it is understood that multiple vias 412 and 912 (not shown in figure 10) are facilitating each connection, thereby providing redundancy and reducing line resistance and capacitance. The back-coupling technique, as illustrated in figure 10, allows short electrical paths and redundant connections to any given anode or cathode line.

In summary and with reference to figures 1 through 10, the back-coupled interconnect system 116 of OLED display assembly 100 allows electrical connections to be located in very close proximity to the OLED devices of OLED display device 112, thereby eliminating the additional capacitance and resistance of long transmission lines such as those required in a typical edge-coupled interconnection system, which is important in a passive matrix configuration. For example, an edge-coupled interconnection system requires wire traces to run from all areas of OLED display device 112 to edge connectors and cables located at the four perimeter edges of OLED display device 112. This is not desirable because these long wire traces have an associated capacitance and resistance that must be overcome by the current drivers in order to achieve the desired performance specifications. However, by using the back-coupled interconnect system 116 of OLED display assembly 100, the length of the transmission line paths from the anodes and cathodes of the OLED devices of OLED display device 112 to the drive/control devices 118 of PCB 114 is minimized, thereby minimizing the parasitic capacitance and resistance of these paths. As a result, the current requirements of, for example, OLED drive circuit 300 as described in reference to figure 4, used in combination with the back-coupling technique of OLED display assembly 100, are optimized, as the additional capacitance and resistance of long wire traces do not exist and thus do not have to be overcome with additional drive current. Furthermore, the redundant connections (i.e., multiple vias 412) connecting to the anode lines within OLED display device 112 overcome the high parasitic resistance of the ITO material making that the common anode configuration can be realized in an optimized manner. Lastly, the back-coupling technique of OLED display assembly 100 eliminates the need for edge connectors for accessing OLED display device 112, thereby allowing pixel array 122 to span the full area of OLED display device 112 and, thus, form a seamless large-screen display when assembled in a tiled arrangement.

The present invention is in no way limited to the forms of embodiment described by way of example and represented in the figures, however, such display assembly can be realized in various forms and dimensions without leaving the scope of the invention.

## Claims

1. Organic light-emitting diode display assembly for use in a large-screen display application, including a display device (112) comprising a plurality of organic light-emitting diodes (OLEDs) (310-312-314) having an anode and a cathode, said display assembly (100) further also including electrode lines formed by anode lines (1-2-3) and cathode lines (4 to 6, 7 to 12), and at least one drive device (118) comprising respective current sources (318), **characterized in that** the organic light-emitting diodes (OLEDs) (310-312-314) are arranged in a common anode configuration, said drive device (118) being configured as a common anode drive device (118).

2. Organic light-emittting diode display assembly according to claim 1, **characterized in that** the current sources (318) are referenced to ground, more particularly are arranged between each individual cathode of the respective OLED and ground.

3. Organic light-emitting diode display assembly according to claim 1 or 2, **characterized in that** the anodes of the respective OLEDs (310-312-314) are electrically connected in common to a positive power supply.

4. Organic light-emitting diode display assembly according to any of the preceding claims, **characterized in that** at least a portion of said display device (112) by means of respective electrical connections is back-coupled to at least one backing element via an interconnect system (116).

5. Organic light-emitting diode display assembly according to claim 4, **characterized in that** all electrical connections of the display device (112) are back-coupled to at least one backing element.

6. Organic light-emitting diode display assembly according to claim 4 or 5, **characterized in that** said backing element consists of a printed circuit board (114) (PCB), extending along the back side of the display device (112).

7. Organic light-emitting diode display assembly according to claim 6, **characterized in that** the drive device (118) includes electronic components forming a driver circuit, at least part of said components being mounted on the side of the printed circuit board (114) opposite to the side at which the interconnect system (116) is provided.

8. Organic light-emitting diode display assembly according to any of the claims 4 to 7, **characterized in that** said interconnect system (116) comprises silver epoxy connections (914) providing a direct connection between the back side of the display device (112) and one side of the backing element.

9. Organic light-emitting diode display assembly according to any of the claims 4 to 8, **characterized in that** at least a number of said electrode lines is provided with connections which are back-coupled to common conductive lines, such as wires (910), on the backing element,so as to reduce the parasitic series resistance of the conductive material used for said electrodes.

10. Organic light-emitting diode display assembly according to any of the claims 4 to 9, **characterized in that** at least a number of said electrode lines is provided with connections which are back-coupled to common conductive lines, e.g. wires (910), on the backing element, so as to reduce the parasitic capacitance of the OLED display device (112) itself.

11. Organic light-emitting diode display assembly according to claim 9 or 10, **characterized in that** said back-coupled connections are at least applied with regard to the anode lines (1-2-3) of the display device (112).

12. Organic light-emitting diode display assembly according to any of the preceding claims, **characterized in that** said anode lines (1-2-3) are arranged along a substrate (120) in a spaced apart manner, whereby multiple pixels (124) each consisting of a plurality of OLEDs (310-312-314) are provided on each anode line, wherein the OLEDs (310-312-314) belonging to the same pixel are in connection with one and the same anode line, said cathode lines (4 to 6, 7 to 12) being directed crosswise with respect to said anode lines (1-2-3).

13. Organic light-emitting diode display assembly according to any of the preceding claims, **characterized in that** one or more of said electrode lines are in connection with one or more contact pads (414) which are located aside of the respective electrode line, said contact pads (414) being provided with a vias (412) allowing to make a connection from the back side of the display device (112) towards the drive device (118).

14. Organic light-emitting diode display assembly according to claim 13, **characterized in that** a plurality of electrode lines is arranged in groups and that at least one of the electrode lines is connected to at least one of said pads (414) by means of a short connection bridging over an adjacent electrode line.

15. Organic light-emitting diode display assembly according to claims 13 or 14, **characterized in that** the anode lines (1-2-3) have a larger width than the cathode lines (4 to 6, 7 to 12), and that a plurality of pads (414) are at least used in connection with the cathode lines (4 to 6, 7 to 12).

16. Organic light-emitting diode display assembly according to any of the preceding claims, **characterized in that** said anode lines (1-2-3) and cathode lines (4 to 6, 7 to 12) define an array, said array defining pixels (124), wherein between the majority of the subsequent pixels (124), at least at the anode lines (1-2-3), connections are provided, allowing an electrical interconnection with the drive device (118) .

17. Organic light-emitting diode display assembly according to any of the preceding claims, **characterized in that** said display assembly (100) is realized in the form of a tile, said tile allowing, together with a plurality of similar tiles, to form a seamless large-screen display when assembled in a tiled arrangement.

18. Large-screen OLED display, **characterized in that** it is composed of organic light-emitting diode display assemblies as claimed in claim 17.
